(19) Europäisches Patentamt
European Patent Office
Office européen des brevets

(11) Veröffentlichungsnummer : **0 446 175 A2**

(12) **EUROPÄISCHE PATENTANMELDUNG**

(21) Anmeldenummer : **91810134.6**

(51) Int. Cl.$^5$ : **C08F 2/50**, G03F 7/029

(22) Anmeldetag : **28.02.91**

(30) Priorität : **09.03.90 CH 764/90**

(43) Veröffentlichungstag der Anmeldung :
**11.09.91 Patentblatt 91/37**

(84) Benannte Vertragsstaaten :
**DE FR GB IT**

(71) Anmelder : **CIBA-GEIGY AG**
**Klybeckstrasse 141**
**CH-4002 Basel (CH)**

(72) Erfinder : **Köhler, Manfred, Dr.**
**Kehlerstrasse 15**
**W-7800 Freiburg (DE)**
Erfinder : **Angerer, Hermann Franz, Dr.**
**Leymenstrasse 13**
**CH-4105 Biel-Benken (CH)**
Erfinder : **Litzler, André**
**rue de la Vièrge 6**
**F-68720 Spechbach-le-Bas (FR)**

(54) **Photoinitiatorgemische.**

(57) Photoinitiatorgemische aus a) 100 Teilen eines Mono- oder Diacylphosphinoxides, b) 10-70 Teilen eines α-Hydroxyacetophenons und c) 10-70 Teilen eines Benzophenones sind wirksame Initiatoren für Photopolymerisationen ethylenisch ungesättigter Verbindungen. Sie sind vor allem für die Photohärtung von Weisslacken geeignet.

EP 0 446 175 A2

Jouve, 18, rue Saint-Denis, 75001 PARIS

## PHOTOINITIATORGEMISCHE

Die Erfindung betrifft Photoinitiatorgemische aus 3 Komponenten und photohärtbare Gemische enthaltend ein solches Photoinitiatorgemisch.

Acylphosphinoxide sind gemäss EP-A-7086 und EP-A-7508 hochwirksame Photoinitiatoren. Neuerdings wurden auch Diacylphosphinoxide für diesen Zweck vorgeschlagen (EP-A-184 095). Wie in der EP-A-7508, Seite 13, angegeben wird, lässt sich die Wirkung der Acylphosphinoxide durch Kombination mit anderen Photoinitiatoren, insbesondere aromatischen Ketonen, noch verstärken. Als Beispiele für solche Co-Initiatoren werden Benzildimethylketal, α-Hydroxyisobutyrophenon, Diethoxyacetophenon, Benzophenon, 2-Methylthioxanthon, 2-Isopropylthioxanthon und 2-Chlorthioxanthon angegeben. Eine weitere Beschleunigung kann durch Zusatz von tertiären Aminen bewirkt werden. Auch in der EP-A-7086, Anspruch 6 und 7, werden Gemische solcher Phosphinoxide mit aromatischen Ketonen, aromatischen Disulfiden oder Naphthalinsulfonylchloriden, insbesondere mit Benzilketalen, Benzoinethern oder Benzoinestern, genannt.

Es wurde nunmehr gefunden, dass sich die Wirkung der Mono- und Diacylphosphinoxide weiter steigern lässt, wenn man sie mit zwei verschiedenen anderen Photoinitiatoren kombiniert, wovon der eine ein α-Hydroxyacetophenon und der andere ein Benzophenon ist. Ein solches Photoinitiatorgemisch eignet sich vor allem zur Photohärtung pigmentierter Massen, insbesondere von Weisslacken.

Gegenstand der Erfindung ist ein Photoinitiatorgemisch, enthaltend

a) 100 Gew.-Teile einer Verbindung der Formel I,

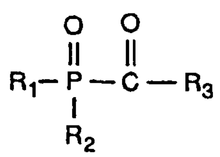

I

worin $R_1$ $C_1$-$C_{18}$-Alkyl, durch Halogen oder $C_1$-$C_6$-Alkoxy substituiertes $C_1$-$C_4$-Alkyl, $C_5$-$C_8$-Cycloalkyl, $C_7$-$C_9$-Phenylalkyl, Phenyl, Naphthyl, Biphenylyl, durch Halogen, $C_1$-$C_{12}$-Alkyl und/oder $C_1$-$C_{12}$-Alkoxy ein- oder mehrfach substituiertes Phenyl, Naphthyl oder Biphenylyl, oder einen einwertigen N-, O- oder S-haltigen 5- oder 6-gliedrigen heterocyclischen Rest bedeutet,

$R_2$ Phenyl, Naphthyl, Biphenylyl durch Halogen, $C_1$-$C_{12}$-Alkyl und/oder $C_1$-$C_{12}$-Alkoxy ein- oder mehrfach substituiertes Phenyl, Naphthyl oder Biphenylyl, einen einwertigen N-, O- oder S-haltigen 5- oder 6-gliedrigen heterocyclischen Rest, $C_1$-$C_{18}$-Alkoxy, Phenoxy, durch Halogen, $C_1$-$C_4$-Alkyl oder $C_1$-$C_4$-Alkoxy substituiertes Phenoxy, Benzyloxy, Cyclohexyloxy oder eine Gruppe -CO-$R_4$ bedeutet,

oder $R_2$ und $R_1$ zusammen mit dem Phosphoratom einen Ring bilden,

$R_3$ $C_1$-$C_{18}$-Alkyl, durch Halogen oder $C_1$-$C_6$-Alkoxy substituiertes $C_1$-$C_4$-Alkyl, $C_5$-$C_8$-Cycloalkyl, $C_7$-$C_9$-Phenylalkyl, Phenyl, Naphthyl, Biphenylyl, durch Halogen, $C_1$-$C_{12}$-Alkyl und/oder $C_1$-$C_{12}$-Alkoxy ein- oder mehrfach substituiertes Phenyl, Naphthyl oder Biphenylyl, einen einwertigen N-, O- oder S-haltigen 5- oder 6-gliedrigen heterocyclischen Rest oder eine Gruppe

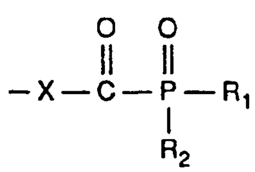

bedeutet, worin X $C_2$-$C_8$-Alkylen, Cyclohexylen oder unsubstituiertes oder durch Halogen, $C_1$-$C_4$-Alkyl oder $C_1$-$C_4$-Alkoxy substituiertes Phenylen oder Biphenylen bedeutet und

$R_4$ $C_1$-$C_{18}$-Alkyl, durch Halogen oder $C_1$-$C_4$-Alkoxy substituiertes $C_1$-$C_4$-Alkyl, $C_5$-$C_8$-Cycloalkyl, $C_7$-$C_9$-Phenylalkyl, Phenyl, Naphthyl, Biphenylyl, durch Halogen, $C_1$-$C_{12}$-Alkyl und/oder $C_1$-$C_{12}$-Alkoxy ein- oder mehrfach substituiertes Phenyl, Naphthyl oder Biphenylyl oder einen einwertigen N-, O- oder S-haltigen 5- oder 6-gliedrigen heterocyclischen Rest bedeutet, oder $R_4$ und $R_3$ zusammen $C_2$-$C_{12}$-Alkylen, Vinylen oder o-Phenylen bedeuten,

b) 10-70 Gew.-Teile einer Verbindung der Formel II,

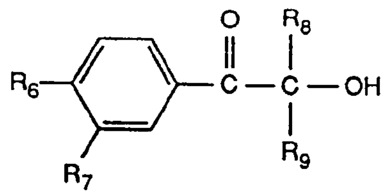

II

worin $R_6$ und $R_7$ unabhängig voneinander Wasserstoff, $C_1$-$C_{18}$-Alkyl, Phenyl, $C_1$-$C_{18}$-Alkoxy, Phenoxy, $C_1$-$C_{18}$-Alkylthio, Phenylthio, $C_2$-$C_8$-Dialkylamino, Piperidino, Morpholino oder Halogen bedeuten und $R_8$ und $R_9$ unabhängig voneinander $C_1$-$C_6$-Alkyl, $C_3$-$C_6$-Alkenyl, $C_7$-$C_9$-Phenylalkyl oder Cyclohexyl bedeuten oder $R_8$ und $R_9$ zusammen $C_4$-$C_6$-Alkylen bedeuten, und

c) 10-70 Gew.-Teile einer Verbindung der Formel III,

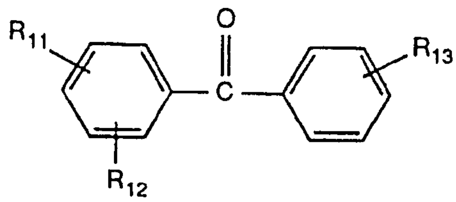

III

worin $R_{11}$, $R_{12}$ und $R_{13}$ unabhänbig voneinander Wasserstoff, $C_1$-$C_{12}$-Alkyl, $C_1$-$C_4$-Alkoxy, $C_1$-$C_4$-Alkylthio, Halogen oder $C_2$-$C_6$-Alkoxycarbonyl bedeuten, oder eines Gemisches von solchen Benzophenonderivaten.

Wenn in diesen Formeln die Substituenten $R_1$, $R_3$, $R_4$, $R_6$, $R_7$, $R_8$, $R_9$, $R_{11}$, $R_{12}$ oder $R_{13}$ Alkyl sind, so kann es sich dabei um unverzweigtes oder verzweigtes Alkyl handeln. Beispiele hierfür sind die Gruppen Methyl, Ethyl, n-Propyl, iso-Propyl, n-Butyl, sec-Butyl, tert-Butyl, n-Pentyl, iso-Pentyl, n-Hexyl, 2-Ethybutyl, n-Octyl, iso-Octyl, 1,1,3,3-Tetramethylbutyl, 2-Ethylhexyl, Nonyl, Decyl, Undecyl, Dodecyl, Tetradecyl, Hexadecyl oder Octadecyl.

Wenn $R_1$, $R_3$ oder $R_4$ durch Halogen oder $C_1$-$C_6$-Alkoxy substituiertes $C_1$-$C_4$-Alkyl ist, so kann dies z.B. Chlormethyl, Trichlormethyl, Trifluormethyl, 2-Chlorethyl, 2-Methoxyethyl, 2-Ethoxypropyl, 2-Butoxyethyl oder 2-Hexyloxyethyl sein.

Wenn $R_1$ oder $R_3$ $C_5$-$C_8$-Cycloalkyl ist, so ist dies vorzugsweise Cyclohexyl. Wenn $R_1$, $R_3$, $R_8$ oder $R_9$ $C_7$-$C_9$-Phenylalkyl ist, so ist dies vorzugsweise Benzyl. Wenn $R_8$ oder $R_9$ $C_3$-$C_6$-Alkenyl ist, so ist dies vorzugsweise Allyl.

Wenn $R_1$, $R_2$, $R_3$ oder $R_4$ durch Halogen, $C_1$-$C_{12}$-Alkyl und/oder $C_1$-$C_{12}$-Alkoxy ein- oder mehrfach substituiertes Phenyl, Naphthyl oder Biphenylyl ist, so kann dies z.B. 4-Chlorphenyl, 2,4-Dichlorphenyl, 2,6-Dichlorphenyl, 2,4,6-Trichlorphenyl, 4-Tolyl, 2-Tolyl, 2,4-Xylyl, 2,4,6-Trimethylphenyl, 4-Isopropylphenyl, 4-tert-Butylphenyl, 4-Octylphenyl, 4-Dodecylphenyl, 4-Methoxyphenyl, 2,4-Dimethoxyphenyl, 2,4,6-Trimethoxyphenyl, 2-Chlor-6-methoxyphenyl, 4-Ethoxyphenyl, 4-Isopropoxyphenyl, 4-Hexyloxyphenyl, 1,3-Dichlor-2-naphthyl, 1,3-Dimethoxy-2-naphthyl, 2,8-Dimethoxy-1-naphthyl, 2,8-Dimethyl-1-naphthyl, 4'-Chlor-4-biphenylyl oder 4'-Ethoxy-4-biphenylyl sein. Bevorzugt handelt es sich hierbei um einen substituierten Phenylrest.

Wenn $R_1$, $R_2$, $R_3$ oder $R_4$ ein N-, O- oder S-haltiger 5- oder 6-gliedriger heterocyclischer Rest ist, so kann dies z.B. 2-, 3- oder 4-Pyridyl, 2,4-Dimethyl-3-pyridyl, 2-Furyl, 2,4-Dimethoxy-3-furyl, 2-Thienyl oder 2,4-Dimethoxy-3-thienyl sein.

$R_{11}$, $R_{12}$ und $R_{13}$ als $C_1$-$C_4$-Alkoxy oder $C_1$-$C_4$-Alkylthio sind vorzugsweise Methoxy, Ethoxy oder Methylthio. $R_2$, $R_6$ oder $R_7$ als $C_1$-$C_{18}$-Alkoxy kann z.B. Methoxy, Ethoxy, Isopropyloxy, tert.Butyloxy, Hexyloxy, Octyloxy oder Dodecyloxy sein. $R_6$ und $R_7$ als $C_1$-$C_{18}$-Alkylthio sind vorzugsweise $C_1$-$C_4$-Alkylthio.

Wenn $R_2$ substituiertes Phenoxy ist, so kann dies z.B. 4-Chlorphenoxy, 2,4-Dichlorphenoxy, 2,4,6-Trichlorphenoxy, 4-Tolyloxy, 2,6-Dimethylphenoxy, 2,4,6-Trimethylphenoxy, 3-Methoxyphenoxy oder 4-Ethoxyphenoxy sein.

Wenn $R_6$ oder $R_7$ $C_2$-$C_8$-Dialkylamino ist, so kann dies z.B. Dimethylamino, Diethylamino, Dipropylamino oder Dibutylamino sein.

Wenn $R_{11}$, $R_{12}$ oder $R_{13}$ $C_2$-$C_6$-Alkoxycarbonyl ist, so ist dies vorzugsweise Methoxycarbonyl oder Ethoxycarbonyl.

Wenn X $C_2$-$C_8$-Alkylen ist, so kann dies z.B. 1,2-Ethylen, Tri-, Tetra-, Penta-, Hexa- oder Octamethylen sein oder auch eine verzweigte Alkylengruppe wie z.B. 1,2-Propylen, Diethylmethylen oder 2,2-Dimethyl-tri-

methylen. Wenn $R_4$ und $R_3$ zusammen $C_2$-$C_{12}$-Alkylen bedeuten, so handelt es sich dabei vorzugsweise um Di- oder Trimethylen, das durch Alkylgruppen substituiert sein kann.

Wenn $R_8$ und $R_9$ zusammen $C_4$-$C_6$-Alkylen bedeuten, so ist dies vorzugsweise Tetra- oder Pentamethylen.

Wenn $R_2$ und $R_1$ zusammen mit dem P-Atom einen Ring bilden, so ist dies vorzugsweise ein 5- oder 6-gliedriger Ring. Der Ring kann Sauerstoff enthalten und kann durch Benzogruppen annelliert sein.

Bevorzugt sind Photoinitiatorgemische, enthaltend

a) 100 Gew.-Teile einer Verbindung der Formel I, worin

$R_1$ unsubstituiertes oder durch Halogen, $C_1$-$C_4$-Alkyl oder $C_1$-$C_4$-Alkoxy substituiertes Phenyl, Naphthyl oder Biphenylyl bedeutet,

$R_2$ unsubstituiertes oder durch Halogen, $C_1$-$C_4$-Alkyl oder $C_1$-$C_4$-Alkoxy substituiertes Phenyl, Naphthyl oder Biphenylyl oder eine Gruppe -CO-$R_4$ bedeutet,

$R_3$ und $R_4$ unabhhängig voneinander $C_1$-$C_{12}$-Alkyl, Cyclohexyl, Benzyl, Phenyl, Naphthyl, Biphenylyl oder durch Halogen, $C_1$-$C_4$-Alkyl und/oder $C_1$-$C_4$-Alkoxy ein- oder mehrfach substituiertes Phenyl, Naphthyl oder Biphenylyl bedeuten,

b) 20-70 Gew.-Teile einer Verbindung der Formel II, worin $R_6$ und $R_7$ unabhängig voneinander Wasserstoff, $C_1$-$C_{12}$-Alkyl, Phenyl, $C_1$-$C_{12}$-Alkoxy, Phenoxy oder Halogen bedeuten und

$R_8$ und $R_9$ unabhängig voneinander $C_1$-$C_4$-Alkyl, Allyl oder Benzyl bedeuten oder $R_8$ und $R_9$ zusammen $C_4$-$C_6$-Alkylen bedeuten, und

c) 10-60 Gew.-Teile einer Verbindung der Formel III, worin $R_{11}$, $R_{12}$ und $R_{13}$ unabhängig voneinander Wasserstoff, $C_1$-$C_6$-Alkyl, $C_1$-$C_4$-Alkoxy oder Halogen bedeuten, oder eines Gemisches von alkylierten Benzophenonen.

Besonders bevorzugt sind Photoinitiatorgemische, enthaltend

a) 100 Gew.-Teile einer Verbindung der Formel I, worin $R_1$ unsubstituiertes oder durch Halogen, $C_1$-$C_4$-Alkyl oder $C_1$-$C_4$-Alkoxy substituiertes Phenyl bedeutet,

$R_2$ unsubstituiertes oder durch Halogen, $C_1$-$C_4$-Alkyl oder $C_1$-$C_4$-Alkoxy substituiertes Phenyl oder eine Gruppe -CO-$R_4$ bedeutet,

$R_3$ und $R_4$ unabhängig voneinander unsubstituiertes oder durch Halogen, $C_1$-$C_4$-Alkyl und/oder $C_1$-$C_4$-Alkoxy substituiertes Phenyl bedeutet,

b) 30-60 Gew.-Teile einer Verbindung der Formel II, worin

$R_6$ und $R_7$ unabhängig voneinander Wasserstoff, $C_1$-$C_{12}$-Alkyl, $C_1$-$C_4$-Alkoxy oder Halogen bedeuten und $R_8$ und $R_9$ unabhängig voneinander $C_1$-$C_4$-Alkyl bedeuten oder $R_8$ und $R_9$ zusammen Tetra- oder Pentamethylen bedeuten, und

c) 20-60 Gew.-Teile einer Verbindung der Formel III, worin

$R_{11}$ und $R_{12}$ Wasserstoff und $R_{13}$ Wasserstoff, $C_1$-$C_4$-Alkyl, $C_1$-$C_4$-Alkoxy oder Halogen bedeuten, oder eines Gemisches von methylierten Benzophenonen.

Beispiele für Verbindungen, die als Komponente a) verwendbar sind, sind die folgenden Verbindungen:

Isobutyroyl-diphenylphosphinoxid
Pivaloyl-diphenylphosphinoxid
Benzoyl-diphenylphosphinoxid
p-Toluyl-diphenylphosphinoxid
p-tert.Butylbenzoyl-diphenylphosphinoxid
α-Naphthoyl-diphenylphosphinoxid
2,6-Dimethylbenzoyl-diphenylphosphinoxid
2,6-Dimethoxybenzoyl-diphenylphosphinoxid
2,4,6-Trimethylbenzoyl-diphenylphosphinoxid
2,6-Dichlorbenzoyl-diphenylphosphinoxid
1,3-Dimethyl-2-naphthoyl-diphenylphosphinoxid
1,3-Dichlor-2-naphthoyl-diphenylphosphinoxid
2,4-Dimethylfuran-3-carbonyl-diphenylphosphinoxid
2,4,6-Trimethylpyridin-3-carbonyl-diphenylphosphinoxid
2,6-Dimethoxybenzoyl-diphenylenphosphinoxid
2,6-Dichlorbenzoyl-ditolylphosphinoxid
Methyl-pivaloyl-phenylphosphinat
Methyl-2,4-dimethylbenzoyl-phenylphosphinat
Bis(2,6-dichlorbenzoyl)-phenylphosphinoxid
Bis(2,6-dichlorbenzoyl)-4-chlorphenylphosphinoxid
Bis(2,6-dichlorbenzoyl)-4-t-butylphenylphosphinoxid
Bis(2,6-dichlorbenzoyl)-1-naphthylphosphinoxid

Bis(2,6-dimethylbenzoyl)-phenylphosphinoxid
Bis(2,6-dimethylbenzoyl)-4-tolylphosphinoxid
Bis(2,6-dimethoxybenzoyl)-phenylphosphinoxid
Bis(2,6-dimethoxybenzoyl)-2-naphthylphosphinoxid
Bis(2,4,6-trimethylbenzoyl)-phenylphosphinoxid
Bis(2,4,6-trimethylbenzoyl)-4-methoxyphenylphosphinoxid
Bis(2-methyl-1-naphthoyl)-phenylphosphinoxid
Bis(2,6-dichlorbenzoyl)-4-propylphenylphosphinoxid.
Besonders bevorzugt als Komponente a) sind
2,4,6-Trimethylbenzoyl-diphenylphosphinoxid und Bis (2,6-dichlorbenzoyl)-4-propylphenylphosphinoxid.

Beispiele für Verbindungen, die als Komponente b) verwendbar sind, sind folgende Verbindungen:
α-Hydroxyisobutyrophenon
p-Isopropyl-α-hydroxyisobutyrophenon
p-t-Butyl-α-hydroxyisobutyrophenon
p-Octyl-α-hydroxyisobutyrophenon
p-Dodecyl-α-hydroxyisobutyrophenon
p-Chlor-α-hydroxyisobutyrophenon
p-Brom-α-hydroxyisobutyrophenon
p-Methoxy-α-hydroxyisobutyrophenon
p-Ethoxy-α-hydroxyisobutyrophenon
3,4-Dimethyl-α-hydroxyisobutyrophenon
3,4-Dimethoxy-α-hydroxyisobutyrophenon
3-Chlor-α-hydroxyisobutyrophenon
α-Hydroxy-α-methylbutyrophenon
α-Hydroxy-α-ethylbutyrophenon
1-Benzoyl-cyclopentanol
1-Benzoyl-cyclohexanol
1-(4-Chlorbenzoyl)-cyclohexanol.
Besonders bevorzugt als Komponente b) ist das 1-Benzoyl-cyclohexanol.

Beispiele für Verbindungen, die als Komponente c) verwendbar sind, sind folgende Verbindungen: Benzophenon, 4-Methylbenzophenon, 2,4-Dimethylbenzophenon, 4-Isopropylbenzophenon, 2-Chlorbenzophenon, 2,2′-Dichlorbenzophenon, 2-Methoxybenzophenon, 4-Methoxybenzophenon, 4-Propoxybenzophenon oder 4-Butoxybenzophenon. Es können auch Gemische von Benzophenonderivaten verwendet werden, z.B. technische Alkylierungsgemische von Benzophenon oder stellungsisomere Benzophenonderivate. Besonders bevorzugt als Komponente c) ist Benzophenon.

Besonders bevorzugt sind Gemische aus 100 Gew.-Teilen 2,4,6-Trimethylbenzoyl-diphenylphosphinoxid, 30-60 Gew.-Teilen 1-Benzoyl-cyclohexanol und 20-40 Gew.-Teilen Benzophenon. Diese Gemische sind flüssig oder niedrig-schmelzend und eignen sich daher besonders zum Zusatz in flüssige photopolymerisierbare Systeme.

Die Photoinitiatorgemische können auch organische Lösungsmittel enthalten. Durch einen solchen Zusatz von Lösungsmittel kann man die Gemische flüssig machen und ihre Viskosität regulieren. Hierzu genügen relativ kleine Mengen an Lösungsmittel, vorzugsweise 5-50 Gew.-Teile auf 100 Gew.-Teile photohärtbares Gemisch. Beispiele von geeigneten Lösungsmitteln sind Isopropanol, Methylethylketon, Butylacetat oder Propylencarbonat.

Die beschriebenen Gemische können erfindungsgemäss als Photoinitiatoren für die Photopolymerisation ethylenisch ungesättigter Verbindungen bzw. Gemische, die solche Verbindungen enthalten, verwendet werden. Die ungesättigten Verbindungen können eine oder mehrere olefinische Doppelbindungen enthalten. Sie können niedermolekular (monomer) oder höhermolekular (oligomer) sein. Beispiele für Monomere mit einer Doppelbindung sind Alkyl- oder Hydroxyalkyl-acrylate oder -methacrylate, wie z.B. Methyl-, Ethyl-, Butyl-, 2-Ethylhexyl- oder 2-Hydroxyethylacrylat, Isobornylacrylat, Methyl- oder Ethylmethacrylat. Weitere Beispiele hierfür sind Acrylnitril, Acrylamid, Methacrylamid, N-substituierte (Meth)acrylamide, Vinylester wie Vinylacetat, Vinylether wie Isobutylvinylether, Styrol, Alkyl- und Halogenstyrole, N-Vinylpyrrolidon, Vinylchlorid oder Vinylidenchlorid.

Beispiele für Monomere mit mehreren Doppelbindungen sind Ethylenglykol-, Propylenglykol-, Neopentylglykol-, Hexamethylenglykol-, oder Bisphenol-A-diacrylat, 4,4′-Bis(2-acryloyloxyethoxy)-diphenylpropan, Trimethylolpropan-triacrylat, Pentaerythrit-triacrylat oder -tetraacrylat, Vinylacrylat, Divinylbenzol, Divinylsuccinat, Diallylphthalat, Triallylphosphat, Triallylisocyanurat oder Tris-(2-acryloyloxyethyl)isocyanurat.

Beispiele für höhermolekulare (oligomere) mehrfach ungesättigte Verbindungen sind acrylierte Epoxidharze, acrylierte Polyether, acrylierte Polyurethane oder acrylierte Polyester. Weitere Beispiele für ungesättigte Oligomere sind ungesättigte Polyesterharze, die meist aus Maleinsäure, Phthalsäure und einem oder mehreren Diolen hergestellt werden und Molekulargewichte von etwa 500 bis 3000 besitzen. Solche ungesättigte Oligomere kann man auch als Prepolymere bezeichnen.

Häufig verwendet man Zweikomponenten-Gemische eines Prepolymeren mit einem mehrfach ungesättigten Monomeren oder Dreikomponentengemische, die ausserdem noch ein einfach ungesättigtes Monomer enthalten. Das Prepolymere ist hierbei in erster Linie für die Eigenschaften des Lackfilmes massgebend, durch seine Variation kann der Fachmann die Eigenschaften des gehärteten Filmes beeinflussen. Das mehrfach ungesättigte Monomere fungiert als Vernetzer, das den Lackfilm unlöslich macht. Das einfach ungesättigte Monomere fungiert als reaktiver Verdünner, mit dessen Hilfe die Viskosität herabgesetzt wird, ohne dass man ein Lösungsmittel verwenden muss.

Solche Zwei- und Dreikomponentensysteme auf der Basis eines Prepolymeren werden sowohl für Druckfarben als auch für Lacke, Photoresists oder andere photohärtbare Massen verwendet. Als Bindemittel für Druckfarben werden vielfach auch Einkomponenten-Systeme auf der Basis photohärtbarer Prepolymerer verwendet.

Ungesättigte Polyesterharze werden meist in Zweikomponentensystemen zusammen mit einem einfach ungesättigten Monomer, vorzugsweise mit Styrol, verwendet. Für Photoresists werden oft spezifische Einkomponentensysteme verwendet, wie z.B. Polymaleinimide, Polychalkone oder Polyimide, wie sie in der DE-OS 2 308 830 beschrieben sind.

Die ungesättigten Verbindungen können auch im Gemisch mit nicht-photopolymerisierbaren filmbildenden Komponenten verwendet werden. Diese können z.B. physikalisch trocknende Polymere bzw. deren Lösungen in organischen Lösungsmitteln sein, wie z.B. Nitrocellulose oder Celluloseacetobutyrat. Diese können aber auch chemisch bzw. thermisch härtbare Harze sein, wie z.B. Polyisocyanate, Polyepoxide oder Melaminharze. Die Mitverwendung von thermisch härtbaren Harzen ist für die Verwendung in sogenannten Hybrid-Systemen von Bedeutung, die in einer ersten Stufe photopolymerisiert werden und in einer zweiten Stufe durch thermische Nachbehandlung vernetzt werden.

Gegenstand der Erfindung sind daher auch photohärtbare Gemische, enthaltend mindestens eine ethylenisch ungesättigte Verbindung und als Photoinitiator ein Gemisch aus a) 100 Gew.-Teilen einer Verbindung der Formel I, b) 10-70 Gew.-Teilen einer Verbindung der Formel II und c) 10-70 Gew.-Teilen einer Verbindung der Formel III.

Die photopolymerisierbaren Gemische können ausser dem Photoinitiator verschiedene Additive enthalten. Beispiele hierfür sind thermische Inhibitoren, die eine vorzeitige Polymerisation verhindern sollen, wie z.B. Hydrochinon oder sterisch gehinderte Phenole. Zur Erhöhung der Dunkellagerstabilität können z.B. Kupferverbindungen, Phosphorverbindungen, quartäre Ammoniumverbindungen oder Hydroxylaminderivate verwendet werden. Zwecks Ausschluss des Luftsauerstoffes während der Polymerisation kann man Paraffin oder ähnliche wachsartige Stoffe zusetzen, die bei Beginn der Polymerisation an die Oberfläche wandern. Als Lichtschutzmittel können in geringer Menge UV-Absorber, wie z.B. solche vom Benztriazol-, Benzophenon-, Hydroxyphenyltriazin- oder Oxalanilid-Typ, zugesetzt werden. Noch besser ist der Zusatz von Lichtschutzmitteln, die UV-Licht nicht absorbieren, wie z.B. von sterisch gehinderten Aminen (HALS).

Zur Beschleunigung der Photopolymerisation können Amine zugesetzt werden, wie z.B. Triethanolamin, N-Methyl-diethanolamin, p-Dimethylaminobenzoesäure-ethylester oder Michlers Keton. Eine Beschleunigung der Photopolymerisation kann weiterhin durch Zusatz von Photosensibilisatoren geschehen, welche die spektrale Empfindlichkeit verschieben bzw. verbreiten. Dies sind insbesondere aromatische Carbonylverbindungen wie z.B. Thioxanthon-, Anthrachinon- und 3-Acylcumarinderivate sowie 3-(Aroylmethylen)-thiazoline.

Die erfindungsgemässen photohärtbaren Zusammensetzungen können für verschiedene Zwecke verwendet werden. In erster Linie ist ihre Verwendung in pigmentierten Anstrichstoffen von Bedeutung. Besonders wertvoll sind die Gemische in Weisslacken, darunter versteht man durch $TiO_2$ pigmentierte Anstrichstoffe. Weitere Einsatzgebiete sind die Strahlenhärtung von Photoresists und gedruckten Schaltungen sowie die Herstellung von Druckplatten. Eine weitere Verwendung ist die für Aussenanstriche, die im Tageslicht oberflächlich nachhärten.

Die Photoinitiatoren werden für die angeführten Anwendungsgebiete zweckmässig in Mengen von 0,1 bis 10 Gew.%, vorzugsweise etwa 0,5 bis 5 Gew.%, bezogen auf das photohärtbare Gemisch, angewendet.

Die Polymerisation erfolgt nach den bekannten Methoden der Photopolymerisation durch Bestrahlung mit Licht, das reich an kurzwelliger Strahlung ist. Als Lichtquellen sind z.B. Quecksilbermitteldruck-, -hochdruck- und -niederdruckstrahler, superaktinische Leuchtstoffröhren, Metallhalogenid-Lampen oder Laser geeignet, deren Emissionsmaxima im Bereich zwischen 250 und 450 nm liegen. Im Falle einer Kombination mit Photosensibilisatoren oder Ferrocenderivaten kann auch längerwelliges Licht oder Laserstrahlen bis 600 nm verwendet werden.

Eine mehrstufige Belichtung mit Strahlungsquellen von verschiedener Intensität oder von verschiedener spektraler Zusammensetzung kann in gewissen Fällen von Vorteil sein. So kann z.B. in einer Primärbelichtung die Wischfestigkeit der Lackoberfläche und in einer Nachbelichtung die Durchhärtung des Lackes erreicht werden.

Die folgenden Beispiele zeigen die Verwendung der erfindungsgemässen Photoinitiatorgemische. Hierin bedeuten Teile Gewichtsteile und Prozente Gewichtsprozente.

Beispiel 1

Ein Weisslack wird bereitet aus
13,5 Teilen Ebecryl® 830 (Polyesteracrylat der Fa. UCB, Belgien),
1,0 Teilen Hexandiol-diacrylat
0,5 Teilen Trimethylolpropan-trisacrylat,
5,0 Teilen Titandioxid (Rutil).

Dazu werden die in Tabelle 1 angegebenen Photoinitiatorgemische zugemischt. Die Lackproben werden in einer Schichtdicke von 200 µm auf Aluminiumbleche, die mit einem weissen Coil-Coat-Lack grundiert sind, aufgetragen.

Die Proben werden in einem PPG-Betrahlungsgerät mit Hg-Mitteldrucklampen (2 x 80 W/cm) bestrahlt. Dabei wird die Anzahl der Durchläufe ermittelt, die zur Härtung (Wischfestigkeit) nötig sind bei einer Durchlaufgeschwindigkeit von 10 m/min (Spalte 1).

Zur Beurteilung der Durchhärtung wird die Pendelhärte nach König (DIN 53157) gemessen (Spalte 2). Anschliessend werden die Proben 16 h mit 5 Lampen von 20 W (Philips TL 05) bestrahlt und danach nochmals die Pendelhärte gemessen (Spalte 3). Hierbei tritt bei allen Proben eine gewisse Nachhärtung ein.

Gemessen wird weiterhin die Vergilbung, die bei dieser 16-stündigen Belichtung auftritt, durch Bestimmung des Yellowness-Index (ASTM D 1925-70) vor und nach dieser Belichtung (Spalte 4 und 5).

Schliesslich wird der 20°-Glanz (ASTM D 523) der Proben mit einem Multiglossgerät gemessen (Spalte 6). Die folgende Tabelle zeigt die Ergebnisse.

Tabelle 1:

| Initiator | 1 | 2 | 3 | 4 | 5 | 6 |
|---|---|---|---|---|---|---|
| 1 % TPO + 0,5 % BCH + 0,5 % BZP | 4 | 41 | 65 | 1,9 | 1,8 | 72 |
| 1,20 % TPO + 0,65 %BCH + 0,65 % BZP | 4 | 53 | 91 | 1,9 | 1,6 | 76 |
| 1,5 % TPO + 0,5 % BCH + 0,5 % BZP | 3 | 39 | 101 | 1,6 | 1,2 | 77 |
| 1,5 % TPO + 0,75 % BCH + 0,75 % BZP | 3 | 41 | 81 | 1,8 | 1,8 | 77 |

1: Anzahl der Durchläufe bis zur Wischfestigkeit
2: Pendelhärte bei Wischfestigkeit (Sekunden)
3: Pendelhärte nach 16 h Nachbelichtung (Sekunden)
4: Yellowness-Index bei Wischfestigkeit
5: Yellowness-Index nach 16 h Nachbelichtung
6: 20°-Glanz (%)
TPO: 2,4,6-Trimethylbenzoyl-diphenylphosphinoxid
BCH: 1-Benzoylcyclohexanol
BZP: Benzophenon

Beispiel 2

Eine Weisslackformulierung auf Basis eines ungesättigten Polyesterharzes und Styrol, pigmentiert mit $TiO_2$, wird mit den in der Tabelle angegebenen Mengen an Photoinitiatoren vermischt und in einer Schichtdicke von 150 µm auf Spanplatten aufgetragen. Die Proben werden 2 Minuten unter vier 40 Watt-Lampen (Philips TL 03) vorgehärtet, anschliessend wird mit einer 120 W/cm-Fusion D-Lampe die maximale Bandgeschwindigkeit bis zur Wischfestigkeit bestimmt - als Mass für die Reaktivität des Photoinitiators.

Unmittelbar nach der Härtung wird die Pendelhärte nach König gemessen (nach DIN 53157). Dann werden die Proben 15 Minuten mit fünf 20 W-Lampen (Philips TL 05) nachgehärtet und anschliessend wieder die Pendelhärte gemessen.

Tabelle 2

| Photoinitiator (Gew.-% bezogen auf Weisslack) | Maximale Bandgeschwindigkeit | Pendelhärte sofort | Pendelhärte nach Nachhärtung |
|---|---|---|---|
| 1,5 % TPO | 10 m/min | 74 | 91 |
| 1,30 % TPO + 0,10 % BCH + 0,10 % BZP | 10 m/min | 91 | 112 |
| 2,5 % TPO | 30 m/min | 66 | 90 |
| 1,30 % TPO + 0,60 % BCH + 0,60 % BZP | 40 m/min | 66 | 91 |

Beispiel 3

Der in Beispiel 1 beschriebene Weisslack wird mit den in Tabelle 3 aufgeführten Photoinitiatoren vermischt und in einer Schichtdicke von 150 µm auf Aluminiumbleche, die mit einem weissen Coil-Coat-Lack grundiert sind, aufgetragen. Die Proben werden zuerst 90 Sekunden mit vier 40 Watt-Lampen (Philips TL 03) bestrahlt. Dann werden die Proben mit einer 120 W/cm Fusion D-Lampe in zwei Durchläufen bei einer Bandgeschwindigkeit von 3 m/min bestrahlt und schliesslich in einem weiteren Durchlauf bei 6 m/min mit zwei 80 W/cm Hg-Mitteldrucklampen (PPG-Gerät) bestrahlt.

Von den Proben wird die Pendelhärte nach König (DIN 53157) sofort nach der Härtung, nach 15 Minuten sowie nach 16 h zusätzlicher Bestrahlung mit vier 40 Watt-Lampen (Philips TL 03) gemessen. Weiterhin wird der Yellowness-Index sofort nach der Härtung und nach 16 h zusätzlicher Bestrahlung gemessen. Schliesslich wird der 20°-Glanz und der 60°-Glanz sofort nach der Härtung und nach 16 h Nachhärtung gemessen. Die Ergebnisse sind in Tabelle 3 aufgeführt.

Tabelle 3:

| Initiator | 1 | 2 | 3 | 4 | 5 | 6 | 7 |
|---|---|---|---|---|---|---|---|
| 1,17 % TPO + 0,5 % BCH + 0,33 % BZP | 146 | 158 | 195 | 2,1 | 0,6 | 65/87 | 65/86 |
| 1,33 % TPO + 0,33 %BCH + 0,33 % BZP | 153 | 156 | 188 | 2,3 | 0,9 | 62/85 | 62/85 |
| 1,33 % BDP + 0,33 % BCH + 0,33 % BZP | 160 | 162 | 174 | 4,7 | 1,2 | 66/85 | 65/86 |
| 1,17 % TPO + 0,5 % BCH + 0,33 % BZP + 0,42 % Isopropanol | 147 | 167 | 190 | 2,0 | 0,6 | 66/86 | 65/87 |
| 1,17 % TPO + 0,5 % BCH + 0,33 % BZP + 0,42 % Propylencarbonat | 147 | 156 | 186 | 2,4 | 0,6 | 76/90 | 76/90 |

1: Pendelhärte (sec) sofort nach Härtung
2: Pendelhärte (sec) nach 15 min Nachhärtung
3: Pendelhärte (sec) nach 16 h Nachhärtung
4: Yellowness-Index sofort nach Härtung
5: Yellowness-Index nach 16 h Nachhärtung
6: 20°/60°-Glanz sofort nach Härtung (%)
7: 20°/60°-Glanz nach 16 h Nachhärtung (%)
TPO: 2,4,6-Trimethylbenzoyl-diphenylphosphinoxid
BDP: Bis(2,6-dichlorbenzoyl)-4-propylphenylphosphinoxid
BCH: 1-Benzoylcyclohexanol
BZP: Benzophenon

Beispiel 4

Der in Beispiel 1 beschriebene Weisslack wird mit den in Tabelle 4 aufgeführten Photoinitiatoren gemischt und in einer Schichtdicke von 200 µm auf weiss grundierte Aluminiumbleche aufgetragen. Die Proben werden mit einer 80 W/cm Hg-Mitteldruck-lampe (Typ Hanovia) in 8 Durchläufen bei 10 m/min Bandgeschwindigkeit bestrahlt.

Zur Beurteilung der Dehnungs- und Haftfestigkeit werden die Proben dem KugeldruckTest nach Erichsen (DIN 53156) unterworfen. Tabelle 4 gibt die Tiefe des Kugeleindruckes an, bis zu welcher der Lackfilm unversehrt bleibt. Je tiefer der Kugeldruck ist, desto elastischer ist der film.

| Photoinitiatoren | Erichsen-Tiefe |
|---|---|
| 1,17 % TPO + 0,5 % BCH + 0,33 % BZP | 1,7 mm |
| 1,17 % TPO + 0,5 % BCH + 0,33 % BZP + 0,42 % Propylencarbonat | 1,5 mm |
| 1 % TPO + 1 % BCH | 1,2 mm |

**Patentansprüche**

1. Photoinitiatorgemisch, enthaltend

a) 100 Gew.-Teile einer Verbindung der Formel I,

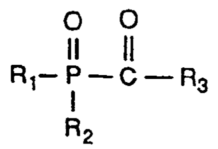

I

worin $R_1$ $C_1$-$C_{18}$-Alkyl, durch Halogen oder $C_1$-$C_6$-Alkoxy substituiertes $C_1$-$C_4$-Alkyl, $C_5$-$C_8$-Cycloalkyl, $C_7$-$C_9$-Phenylalkyl, Phenyl, Naphthyl, Biphenylyl, durch Halogen, $C_1$-$C_{12}$-Alkyl und/oder $C_1$-$C_{12}$-Alkoxy ein- oder mehrfach substituiertes Phenyl, Naphthyl oder Biphenylyl, oder einen einwertigen N-, O- oder S-haltigen 5- oder 6-gliedrigen heterocyclischen Rest bedeutet,
$R_2$ Phenyl, Naphthyl, Biphenylyl durch Halogen, $C_1$-$C_{12}$-Alkyl und/oder $C_1$-$C_{12}$-Alkoxy ein- oder mehrfach substituiertes Phenyl, Naphthyl oder Biphenylyl, einen einwertigen N-, O- oder S-haltigen 5- oder 6-gliedrigen heterocyclischen Rest, $C_1$-$C_{18}$-Alkoxy, Phenoxy, durch Halogen, $C_1$-$C_4$-Alkyl oder $C_1$-$C_4$-Alkoxy substituiertes Phenoxy, Benzyloxy, Cyclohexyloxy oder eine Gruppe -CO-$R_4$ bedeutet,
oder $R_2$ und $R_1$ zusammen mit dem Phosphoratom einen Ring bilden,
$R_3$ $C_1$-$C_{18}$-Alkyl, durch Halogen oder $C_1$-$C_6$-Alkoxy substituiertes $C_1$-$C_4$-Alkyl, $C_5$-$C_8$-Cycloalkyl, $C_7$-$C_9$-Phenylalkyl, Phenyl, Naphthyl, Biphenylyl, durch Halogen, $C_1$-$C_{12}$-Alkyl und/oder $C_1$-$C_{12}$-Alkoxy ein- oder mehrfach substituiertes Phenyl, Naphthyl oder Biphenylyl, einen einwertigen N-, O- oder S-haltigen 5- oder 6-gliedrigen heterocyclischen Rest oder eine Gruppe

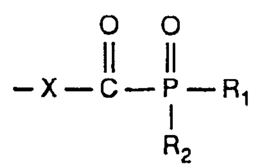

bedeutet, worin X $C_2$-$C_8$-Alkylen, Cyclohexylen oder unsubstituiertes oder durch Halogen, $C_1$-$C_4$-Alkyl oder $C_1$-$C_4$-Alkoxy substituiertes Phenylen oder Biphenylen bedeutet und
$R_4$ $C_1$-$C_{18}$-Alkyl, durch Halogen oder $C_1$-$C_4$-Alkoxy substituiertes $C_1$-$C_4$-Alkyl, $C_5$-$C_8$-Cycloalkyl, $C_7$-$C_9$-Phenylalkyl, Phenyl, Naphthyl, Biphenylyl, durch Halogen, $C_1$-$C_{12}$- Alkyl und/oder $C_1$-$C_{12}$-Alkoxy ein- oder mehrfach substituiertes Phenyl, Naphthyl oder Biphenylyl oder einen einwertigen N-, O- oder S-haltigen 5- oder 6-gliedrigen heterocyclischen Rest bedeutet, oder $R_4$ und $R_3$ zusammen $C_2$-$C_{12}$-Alkylen, Vinylen oder o-Phenylen bedeuten,

b) 10-70 Gew.-Teile einer Verbindung der Formel II,

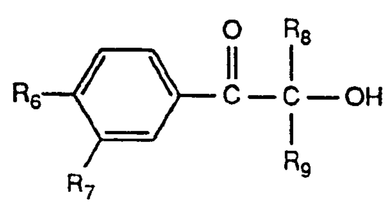

II

worin $R_6$ und $R_7$ unabhängig voneinander Wasserstoff, $C_1$-$C_{18}$-Alkyl, Phenyl,$C_1$-$C_{18}$-Alkoxy, Phenoxy, $C_1$-$C_{18}$-Alkylthio, Phenylthio, $C_2$-$C_8$-Dialkylamino, Piperidino, Morpholino oder Halogen bedeuten und $R_8$ und $R_9$ unabhängig voneinander $C_1$-$C_6$-Alkyl, $C_3$-$C_6$-Alkenyl, $C_7$-$C_9$-Phenylalkyl oder Cyclohexyl bedeuten oder $R_8$ und $R_9$ zusammen $C_4$-$C_6$-Alkylen bedeuten, und

c) 10-70 Gew.-Teile einer Verbindung der Formel III,

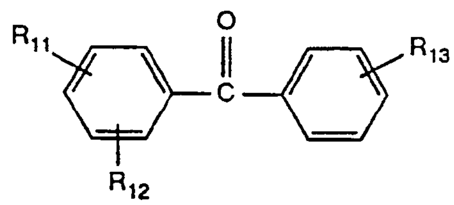

III

worin $R_{11}$, $R_{12}$ und $R_{13}$ unabhängig voneinander Wasserstoff, $C_1$-$C_{12}$-Alkyl, $C_1$-$C_4$-Alkoxy, $C_1$-$C_4$-Alkylthio, Halogen oder $C_2$-$C_6$-Alkoxycarbonyl bedeuten, oder eines Gemisches von solchen Benzophenonderivaten.

**2.** Photoinitiatorgemisch gemäss Anspruch 1, enthaltend
a) 100 Gew.-Teile einer Verbindung der Formel I, worin
$R_1$ unsubstituiertes oder durch Halogen, $C_1$-$C_4$-Alkyl oder $C_1$-$C_4$-Alkoxy substituiertes Phenyl, Naphthyl oder Biphenylyl bedeutet,
$R_2$ unsubstituiertes oder durch Halogen, $C_1$-$C_4$-Alkyl oder $C_1$-$C_4$-Alkoxy substituiertes Phenyl, Naphthyl oder Biphenylyl oder eine Gruppe -CO-$R_4$ bedeutet,
$R_3$ und $R_4$ unabhhängig voneinander $C_1$-$C_{12}$-Alkyl, Cyclohexyl, Benzyl, Phenyl, Naphthyl, Biphenylyl oder durch Halogen, $C_1$-$C_4$-Alkyl und/oder $C_1$-$C_4$-Alkoxy ein- oder mehrfach substituiertes Phenyl, Naphthyl oder Biphenylyl bedeuten,
b) 20-70 Gew.-Teile einer Verbindung der Formel II, worin $R_6$ und $R_7$ unabhängig voneinander Wasserstoff, $C_1$-$C_{12}$-Alkyl, Phenyl, $C_1$-$C_{12}$-Alkoxy, Phenoxy oder Halogen bedeuten und
$R_8$ und $R_9$ unabhängig voneinander $C_1$-$C_4$-Alkyl, Allyl oder Benzyl bedeuten oder $R_8$ und $R_9$ zusammen $C_4$-$C_6$-Alkylen bedeuten, und
c) 10-60 Gew.-Teile einer Verbindung der Formel III, worin $R_{11}$, $R_{12}$ und $R_{13}$ unabhängig voneinander Wasserstoff, $C_1$-$C_6$-Alkyl, $C_1$-$C_4$-Alkoxy oder Halogen bedeuten, oder eines Gemisches von alkylierten Benzophenonen.

**3.** Photoinitiatorgemisch gemäss Anspruch 1, enthaltend
a) 100 Gew.-Teile einer Verbindung der Formel I, worin $R_1$ unsubstituiertes oder durch Halogen, $C_1$-$C_4$-Alkyl oder $C_1$-$C_4$-Alkoxy substituiertes Phenyl bedeutet,
$R_2$ unsubstituiertes oder durch Halogen, $C_1$-$C_4$-Alkyl oder $C_1$-$C_4$-Alkoxy substituiertes Phenyl oder eine Gruppe -CO-$R_4$ bedeutet,
$R_3$ und $R_4$ unabhängig voneinander unsubstituiertes oder durch Halogen, $C_1$-$C_4$-Alkyl und/oder $C_1$-$C_4$-Alkoxy substituiertes Phenyl bedeutet,
b) 30-60 Gew.-Teile einer Verbindung der Formel II, worin
$R_6$ und $R_7$ unabhängig voneinander Wasserstoff, $C_1$-$C_{12}$-Alkyl, $C_1$-$C_4$-Alkoxy oder Halogen bedeuten und
$R_8$ und $R_9$ unabhängig voneinander $C_1$-$C_4$-Alkyl bedeuten oder $R_8$ und $R_9$ zusammen Tetra- oder Pentamethylen bedeuten, und
c) 20-60 Gew.-Teile einer Verbindung der Formel III, worin
$R_{11}$ und $R_{12}$ Wasserstoff und $R_{13}$ Wasserstoff, $C_1$-$C_4$-Alkyl, $C_1$-$C_4$-Alkoxy oder Halogen bedeuten, oder eines Gemisches von methylierten Benzophenonen.

**4.** Photoinitiatorgemisch gemäss Anspruch 1, worin die Komponente a) 2,4,6-Trimethylbenzoyl-diphenylphosphinoxid ist.

**5.** Photoinitiatorgemisch gemäss Anspruch 1, worin die Komponente a) Bis(2,6-dichlorbenzoyl)-4-propylphenylphosphinoxid ist.

**6.** Photoinitiatorgemisch gemäss Anspruch 1, worin die Komponente b) 1-Benzoylcyclohexanol ist.

**7.** Photoinitiatorgemisch gemäss Anspruch 1, worin die Komponente c) Benzophenon ist.

**8.** Photoinitiatorgemisch gemäss Anspruch 1, bestehend aus 100 Gew.-Teilen 2,4,6-Trimethylbenzoyl-diphenylphosphinoxid, 30-60 Gew.-Teilen 1 -Benzoylcyclohexanol und 20-40 Gew.-Teilen Benzophenon.

**9.** Photoinitiatorgemisch gemäss Anspruch 1, enthaltend auf 100 Gew.-Teile des Gemisches aus a, b und c 5-50 Gew.-Teile eines organischen Lösungsmittels.

**10.** Photoinitiatorgemisch gemäss Anspruch 9, bestehend aus 100 Gew.-Teilen 2,4,6-Trimethylbenzoyl-diphenylphosphinoxid, 35-50 Gew.-Teilen 1 -Benzoylcyclohexanol, 25-35 Gew.-Teilen Benzophenon und 20-30 Gew.-Teilen Isopropanol.

**11.** Photohärtbares Gemisch enthaltend mindestens eine ethylenisch ungesättigte photopolymerisierbare Verbindung und als Photoinitiator ein Gemisch gemäss Anspruch 1.

**12.** Photohärtbares Gemisch gemäss Anspruch 11, enthaltend ein Pigment, insbesondere ein weisses Pigment.

**13.** Photohärtbares Gemisch gemäss Anspruch 11, enthaltend 0,1 bis 10 Gew.-% eines Photoinitiatorgemisches gemäss Anspruch 1.

**14.** Photohärtbares Gemisch gemäss Anspruch 11, enthaltend 0,5 bis 5 Gew.-% eines Photoinitiatorgemisches gemäss Anspruch 1.